Europäisches Patentamt

(19) European Patent Office

Office européen des brevets

(11) EP 0 779 659 A2

(12) EUROPEAN PATENT APPLICATION

(43) Date of publication:
18.06.1997 Bulletin 1997/25

(51) Int. Cl.$^6$: H01L 27/092

(21) Application number: 96119726.6

(22) Date of filing: 09.12.1996

(84) Designated Contracting States:
DE FR GB

(30) Priority: 15.12.1995 JP 327176/95

(71) Applicant: NEC CORPORATION
Tokyo (JP)

(72) Inventor: Murakami, Kouichi
Minato-ku, Tokyo (JP)

(74) Representative: Baronetzky, Klaus, Dipl.-Ing. et al
Patentanwälte
Dipl.-Ing. R. Splanemann, Dr. B. Reitzner, Dipl.-Ing. K. Baronetzky
Tal 13
80331 München (DE)

(54) Semiconductor integrated circuit

(57) A semiconductor integrated circuit includes a high speed operation circuit section constituted by serial signal processing circuits having an S/P converter (11), a P/S converter (13) and a clock n-divider (14), and a low speed operation circuit section constituted by parallel signal processing circuits having a digital signal processing circuit (12) allowed to be operated at a lower speed than that of the high speed operation circuit. The capacitance (i.e., parasitic capacitance) of transistors constituting the digital signal processing circuit is increased to provide longer signal rise and fall times for the transistors, thus suppressing the electromagnetic irradiation from the low speed operation circuit section and making the integrated circuit highly immune to noise.

FIG. 3

Printed by Rank Xerox (UK) Business Services
2.14.7/3.4

**Description**

BACKGROUND OF THE INVENTION

(1) Field of the Invention

The present invention relates to semiconductor integrated circuits in which the electromagnetic irradiation generated is reduced, and more particularly to semiconductor integrated circuits in which the electromagnetic irradiation resulting from the on-off operation of transistor elements is reduced.

(2) Description of the Related Art

In recent semiconductor integrated circuits, transistor elements thereof are sources of electromagnetic irradiation due to high frequency components in the rise and fall times of their high speed on-off operation. The electromagnetic irradiation causes electromagnetic interference problems in nearby circuits and equipment, thus giving rise to performance deterioration and erroneous operation of these circuits and equipment.

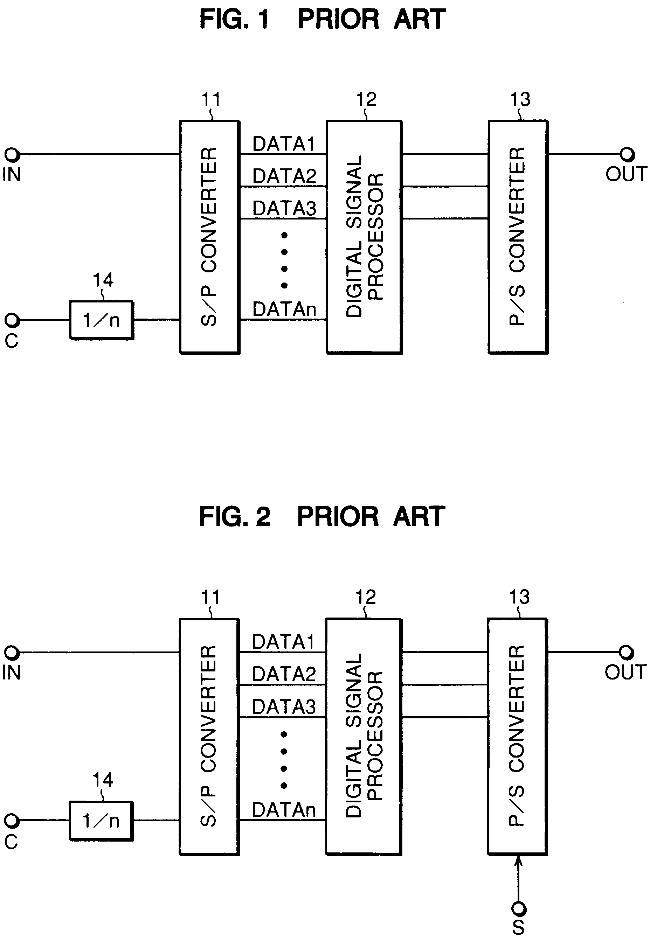

As an example, Fig. 1 shows a circuit for processing a serial signal by converting it into parallel data signals. In this circuit, an S/P (serial-parallel) converter 11 converts a serial data signal inputted at frequency f from a data input terminal IN into n parallel data according to the output of a clock n-divider 14 that divides by n the clock signal inputted from a clock input terminal C, and outputs a sequence of n-parallel data 1 - n of frequency f/n. A digital signal processor 12 executes predetermined processing on the n parallel data. A P/S (parallel-serial) converter 13 converts the n parallel data having been processed in the digital signal processor 12 into a serial signal, and outputs it as data of frequency f from a data output terminal OUT.

The above data processing circuit comprises MOS transistors, for instance, as its semiconductor elements which are all designed so as to drive their gate at a maximum operating frequency. This means that the rise and fall times of the MOS transistors are extremely short, thus giving rise to high frequency wave generation and electromagnetic wave irradiation as described above. Techniques for reducing such electromagnetic irradiation have been proposed in, for instance, Japanese Patent Application Kokai Publication No. Sho 64-15820 and Japanese Patent Application Kokai Publication No. Hei 3-129416. In the former technique, a circuit generates a clock frequency that is necessary for its own operation from a clock inputted at a frequency lower than the necessary high clock frequency, thus reducing electromagnetic irradiation unlike the case where the high clock frequency is inputted to an input section. In the latter technique, a sine wave is inputted into an input section and this sine wave is converted into a rectangular wave in the circuit. This arrangement also has an effect of preventing the rectangular wave from being inputted into the input section thereby reducing the electromagnetic wave irradiation in the input section.

While the electromagnetic interference (EMI) has been described above, the electromagnetic susceptibility (EMS) or immunity which is a converse character also has adverse effects on semiconductor integrated circuits in which transistors are turned on-off at high speeds. The fact that the transistors are turned on-off at high speeds means that the transistors are sensitive to even slight noise, and is a cause of ready occurrence of erroneous operations. Fig. 2 illustrates an example of processing of a serial signal by converting the same signal into parallel data. Here the S/P converter 11 converts a serial data signal inputted at frequency f from a data input terminal IN into n parallel data according to the output of a clock n-divider 14 that divides by n the clock signal inputted from a clock input terminal C, and outputs a sequence of n-parallel data 1 - n of frequency f/n. The digital signal processor 12 executes the predetermined processing on the n parallel data. The P/S converter 13 converts the n parallel data having been processed in the digital signal processor 12 into the serial signal, and outputs it as data of frequency f from the data output terminal OUT. The P/S converter 13 further has an output control signal input terminal S and, when a control signal is outputted therefrom, it ceases the output of data from the output terminal OUT.

In such a circuit, all the constituent semiconductor elements thereof, i.e., MOS transistors, are designed so as to drive their gates at a maximum operating frequency. Therefore, the rise and fall times of the MOS transistors are extremely short, the cut-off frequency of the elements is high, and the elements become more sensitive to noise. Particularly, the terminals such as control input terminals S which form external terminals are sensitive to noise and become a cause of erroneous operation.

With the above disclosed techniques, it is difficult to reduce the electromagnetic irradiation from the circuit since the elements therein are still operated at a high speed, although it is possible to prevent the electromagnetic irradiation from the input section at which there was conventionally pronounced electromagnetic irradiation. Besides, the semiconductor integrated circuits which are obtainable according to the disclosed techniques require such additional components as a frequency converter and a waveform shaper. These additional circuit components increase the scale of the circuit and are therefore undesired for realizing a small size and high integration density semiconductor integrated circuit. The second problem in the disclosed techniques is the sensitivity to external noise, giving rise to erroneous operations. This is so because the element transistors have a high cut-off frequency and are therefore sensitive to high frequency noise as well.

## SUMMARY OF THE INVENTION

An object of the invention, therefore, is to provide a semiconductor integrated circuit which enables the effective reduction of the electromagnetic irradiation in its circuit sections and is also highly immune to noise.

According to one aspect of the invention, there is provided a semiconductor integrated circuit comprising:

a high speed operation circuit section required to perform a high speed operation; and

a low speed operation circuit section allowed to be operated at a lower speed than that of the high speed operation circuit section, in which rise and fall times are longer than those in the high speed operation circuit section.

Generally, the electromagnetic irradiation from such elements as MOS transistors and bipolar transistors is inversely proportional to the rise and fall times of signals, that is, it is increased with increasing speed of operation. This means that although the circuit sections requiring a high frequency have to be realized such that they drive their gates with short signal rise and fall times, the electromagnetic irradiation in at least circuit sections requiring a low frequency can be reduced by constructing these circuit sections with element transistors, which are driven with increased signal rise and fall times by increasing the channel length or reducing the bias voltage or increasing the output capacitance (i.e., parasitic capacitance). Besides, the elements have a low cut-off frequency and hence is less sensitive to noise, and it is possible to provide a semiconductor integrated circuit which has increased immunity to noise.

## BRIEF DESCRIPTION OF THE DRAWINGS

The above and other objects, features and advantages of the present invention will be apparent from the following description of preferred embodiments of the invention explained with reference to the accompanying drawings, in which:

Fig. 1 is a block diagram showing a prior art semiconductor integrated circuit;

Fig. 2 is a block diagram showing another prior art semiconductor integrated circuit;

Fig. 3 is a block diagram showing a first embodiment of the semiconductor integrated circuit according to the invention;

Figs. 4A and 4B are waveform diagrams showing the signal rise and fall times in various circuit sections shown in Fig. 1, Fig. 4A showing the signal rise and fall times in high speed operation circuit sections, Fig. 4B showing the signal rise and fall times in low speed operation circuit sections;

Fig. 5 is a block diagram showing a second embodiment of the semiconductor integrated circuit according to the invention;

Fig. 6 is a block diagram showing a third embodiment of the semiconductor integrated circuit according to the invention;

Figs. 7A and 7B are waveform diagrams showing signal rise and fall times in various circuit sections shown in Fig. 6, Fig. 7A showing the signal rise and fall times in high speed operation circuit sections, Fig. 7B showing the signal rise and fall times in low speed operation circuit sections;

Fig. 8 is a graph showing an envelope of Fourier Coefficient spectrum of trapezoidal waves in Figs. 7A and 7B;

Fig. 9 is a block diagram showing a fourth embodiment of the semiconductor integrated circuit according to the invention; and

Fig. 10 is a plan view showing the physical location of the semiconductor integrated circuit according to the invention.

## PREFERRED EMBODIMENTS OF THE INVENTION

Now, preferred embodiments of the invention are explained with reference to the drawings.

A first embodiment of the invention, like the prior art circuit described above, concerns a circuit for processing a data signal by making the serial-parallel conversion thereof. Specifically, the S/P converter 11 shown in Fig. 1 converts the serial data signal inputted at frequency f from the data signal input terminal IN into n parallel data, and outputs a sequence of n-parallel data 1 - n of frequency f/n. The clock n-divider 14 divides the clock signal from the clock input terminal C by n and inputs the resultant signal to the S/P converter 11 for the conversion of the serial signal to the parallel data. The digital signal processor 12 executes the predetermined processing on the n parallel data. The P/S converter 13 converts the n parallel data having been processed in the digital signal processor 12 into the serial signal, and outputs it as data of frequency f which is outputted from the data output terminal OUT.

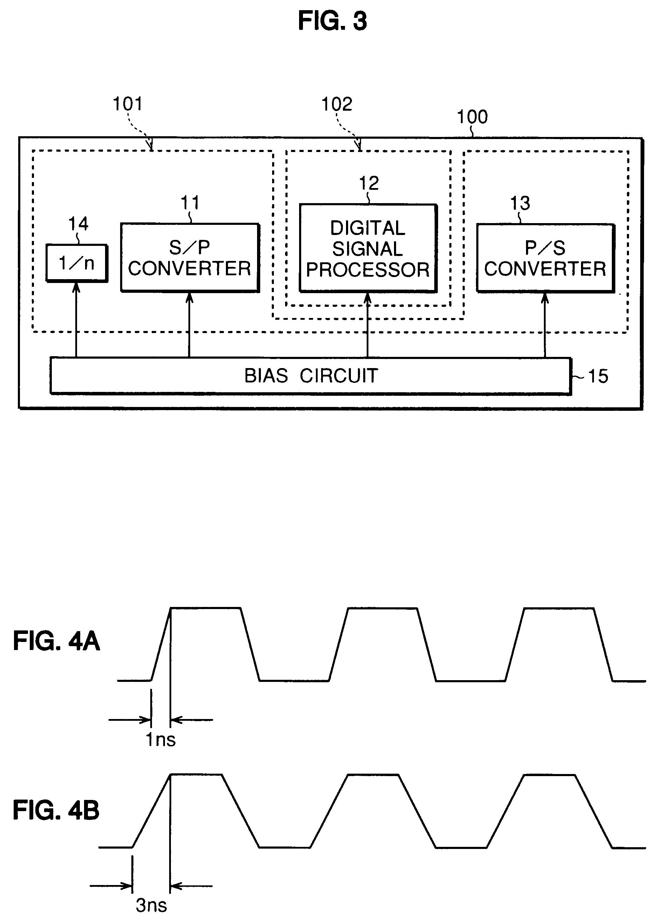

Fig. 3 is a block diagram showing the circuit shown in Fig. 1, which is fabricated as a semiconductor integrated circuit on a semiconductor substrate 100. A short channel element region 101 which constitutes the S/P converter 11, the P/S converter 13 and the clock n-divider (i.e., 1/n divider) 14, has its elements fabricated as short channel MOS transistors capable of operating at a high speed with short rise and fall times. On the other hand, a long channel element region 102 which constitutes the digital signal processor 12, has its elements fabricated as long channel MOS transistors operable with long rise and fall times because these elements are operated at a relatively low speed corresponding to the frequency f/n. A bias circuit 15 supplies a bias to the circuit sections described above.

When this semiconductor integrated circuit is driven, with the input of a signal or clock at frequency f, the S/P converter 11, P/S converter 13 and clock n-divider 14 are operated in a state with as short rise and fall times as approximately 1 ns, as shown in Fig. 4A, because of the short channel of their constituent MOS transistors. On the other hand, with the same signal inputted at frequency f, the digital signal processor 12 is operated with longer rise and fall times of approximately 3 ns, as shown in Fig. 4B, because of the longer channel of its constituent MOS transistors. In this case, the digital signal processor 12 is operated at frequency f/n, and its operation is not adversely affected by the longer rise and fall times.

The digital signal processor 12 constitutes a major part of the semiconductor integrated circuit, and it is constructed with the long channel MOS transistors so that it is possible to increase the rise and fall times for these MOS transistors without resultant adverse effects on its operation. As already described, the electromagnetic irradiation accompanying the MOS transistor operation is inversely proportional to the rise and fall times, and this means that it is possible to reduce the electromagnetic irradiation in the digital signal processor 12. In this embodiment, the rise and fall times are increased from 1 ns to 3 ns for the digital signal processor 12 to obtain corresponding electromagnetic irradiation reduction therein.

Even though electromagnetic irradiation is generated as in the prior art in other circuit sections, i.e., the S/P converter 11, P/S converter 13 and clock n-divider 14, the electromagnetic irradiation generated in the overall semiconductor integrated circuit is remarkably reduced because these other circuit sections together constitute only a small proportion of the circuit.

A second embodiment of the invention will now be described.

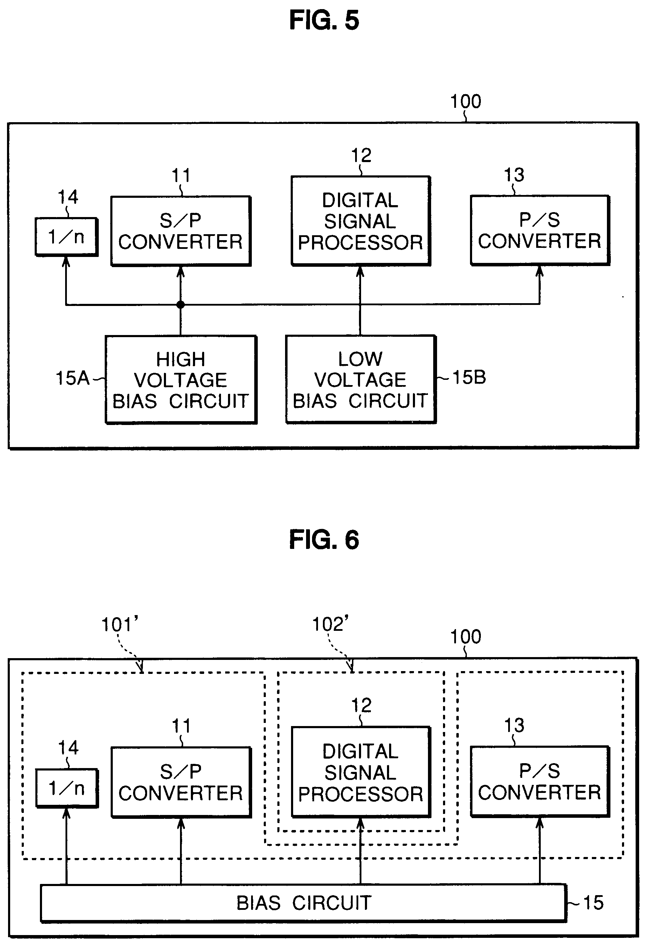

Fig. 5 is a block diagram similar to Fig. 3 but showing the second embodiment of the invention applied again to the circuit shown in Fig. 1. In this embodiment, the S/P converter 11, the digital signal processor 12, the P/S converter 13 and the clock n-divider (i.e., 1/n divider) 14 are constructed with elements having the same structure, for instance, MOS transistors having the same channel length, and the embodiment further comprises a high voltage bias circuit 15A and a low voltage bias circuit 15B. The high voltage bias circuit 15A applies a high voltage as gate-drain bias to the MOS transistors of the S/P converter 11, P/S converter 13 and clock n-divider 14 to permit high speed operation thereof with short rise and fall times corresponding to frequency f. The low voltage bias circuit 15B, on the other hand, applies a low voltage as gate-drain bias to the MOS transistors of the digital signal processor 12 to increase the rise and fall times for operation at a relatively low speed corresponding to frequency f/n.

When this semiconductor integrated circuit is driven, with the input of a signal or clock at frequency f, the S/P converter 11, P/S converter 13 and clock n-divider 14 are operated in a state with as short rise and fall times as approximately 1 ns as shown in Fig. 4A since the high voltage bias is supplied to their MOS transistors. On the other hand, with the same signal inputted at frequency f, the digital signal processor 12 is operated in a state with longer rise and fall times of approximately 3 ns, as shown in Fig. 4B, since the low voltage bias is supplied to its MOS transistors.

Again in this second embodiment, the digital signal processor 12 constitutes a major part of the semiconductor integrated circuit, so that it is possible to increase the rise and fall times for the digital signal processor 12 without resultant adverse effects on the operation. This means that it is possible to reduce the electromagnetic irradiation in the digital signal processor 12 constituting a major part of the circuit. Even though electromagnetic irradiation is generated as in the prior art in other circuit sections, i.e., the S/P converter 11, P/S converter 13 and clock n-divider 14, the electromagnetic irradiation generated in the overall semiconductor integrated circuit is remarkably reduced because these other circuit sections together constitute only a small proportion of the circuit.

While the above first and second embodiments relate to the application of the invention to the semiconductor integrated circuit which is for serial-parallel conversion and for carrying out digital signal processing, the invention is generally applicable to any semiconductor integrated circuit having a high speed operation circuit section and a low speed operation circuit section.

While the above embodiments used the MOS transistors as operating elements, particularly the construction of the second embodiment in which different biases are supplied to the circuit, is also applicable to a circuit using bipolar transistors as operating elements.

A third embodiment of the invention will now be described.

Fig. 6 is a block diagram showing the third embodiment, the block diagram corresponding to that of Fig. 3 for the first embodiment in which the present invention is applied to the circuit shown in Fig. 1.

A low capacitance (parasitic capacitance) region 101' which constitutes the S/P converter 11, the P/S converter 13 and the clock n-divider (i.e., 1/n divider) 14, has its elements fabricated as low output capacitance (parasitic capacitance), high cut-off frequency MOS transistors capable of operating at a high speed with short rise and fall times corresponding to frequency f. A high capacitance (parasitic capacitance) region 102' which constitutes the digital signal processor 12, on the other hand, is operated at a relatively low speed corresponding to frequency f/n. The elements of this region are thus fabricated as high output capacitance (parasitic capacitance), low cut-off frequency MOS transistors for operation with longer rise and fall times. A bias circuit 15 is provided for supplying a bias to the various circuit sections mentioned above.

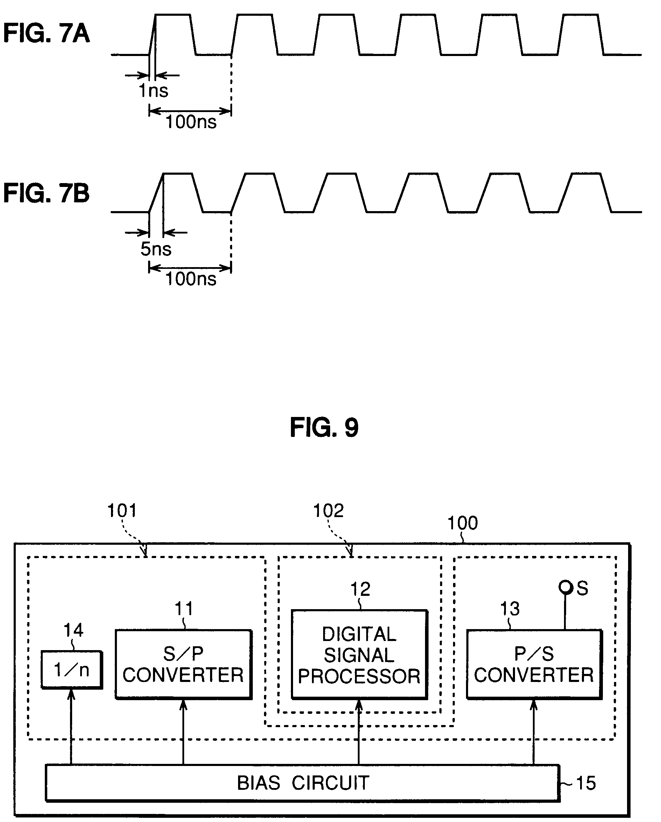

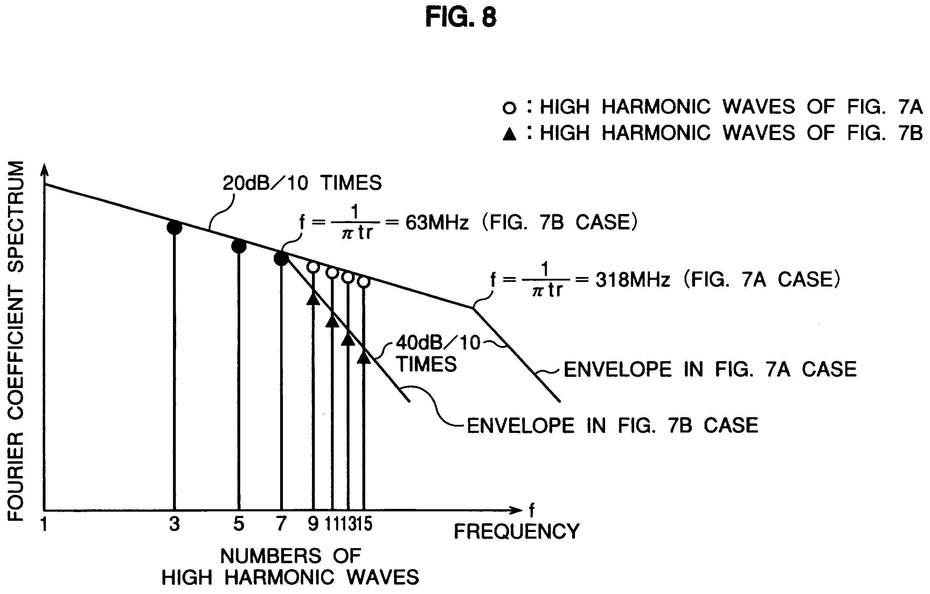

When this semiconductor integrated circuit is driven, with the input of a signal or clock at frequency f, the S/P converter 11, P/S converter 13 and clock n-divider 14 are operated in a state with as short rise and fall times as approximately 1 ns, as shown in Fig. 7A, because of the low output capacitance (parasitic capacitance) of their constituent MOS transistors. On the other hand, with the same signal inputted at frequency f, the digital signal processor 12 is operated with longer rise and fall times of approximately 5 ns, as shown in Fig. 7B, because of the higher output capacitance (parasitic capacitance) of its constituent MOS transistors. In this case, the digital signal processor 12 is operated at frequency f/n, and its operation is not adversely affected by the longer rise and fall times.

Again in this semiconductor integrated circuit, a major part thereof is constituted by the digital signal processor 12, which is constructed with the high Output capacitance (parasitic capacitance) MOS transistors, so that it is possible to increase the rise and fall times for these MOS transistors without resultant adverse effects on operation.

As already described, the electromagnetic irradiation accompanying the MOS transistor operation is inversely proportional to the rise and fall times, which means the possibility of reducing the electromagnetic irradiation in the digital signal processor 12. In this embodiment, the rise and fall times are increased from 1 ns to 5 ns to obtain corresponding electromagnetic irradiation reduction, as will be seen from the following calculation.

The following equation 1 is given as a trapezoidal wave equation.

## Equation 1

$$I_n = \frac{2I\sin(n\pi d)}{n\pi} \cdot \frac{\sin(n\pi tr/T)}{n\pi tr/T}$$

where I is the peak to peak value, d is the duty cycle, tr is the rise and fall times, T is the cycle period, and n is the harmonic degree.

In the case of Fig. 7A, d = 0.5 (50%), tr = 1 ns, f = 10 MHz, and T = 100 ns.

The eleventh harmonic is given as the following equation 2.

## Equation 2

$$I_{11} = \frac{2I\sin(11\pi \cdot 0.5)}{11\pi} \cdot \frac{\sin(11\pi \dfrac{1}{100})}{11\pi \dfrac{1}{100}}$$

$$= \frac{2I}{11\pi} \cdot \frac{0.338}{11\pi \dfrac{1}{100}}$$

In the case of Fig. 7B, d = 0.5 (50%), tr = 5 ns, f = 10 MHz, T = 100 ns, and the eleventh harmonic is given as the following equation 3.

## Equation 3

$$I_{11} = \frac{2I\sin(11\pi \cdot 0.5)}{11\pi} \cdot \frac{\sin\left(11\pi \dfrac{5}{100}\right)}{11\pi \dfrac{5}{100}}$$

$$= \frac{2I}{11\pi} \cdot \frac{0.1975}{11\pi \dfrac{1}{100}}$$

The equation 3 means that the irradiation is reduced by 58% (or 4.7 dB) compared to the irradiation given by the equation 2.

Fig. 8 is a graph showing the trapezoidal wave envelope curves in the cases of Figs. 7A and 7B. As will be seen from Fig. 8, the higher the harmonic degree, the electromagnetic irradiation is reduced more with increasing rise and fall times.

Even though electromagnetic irradiation is generated as in the prior art in other circuit sections, i.e., the S/P converter 11, P/S converter 13 and clock n-divider 14, the electromagnetic irradiation generated in the overall semiconductor integrated circuit is remarkably reduced because these other circuit sections together constitute only a small proportion of the circuit.

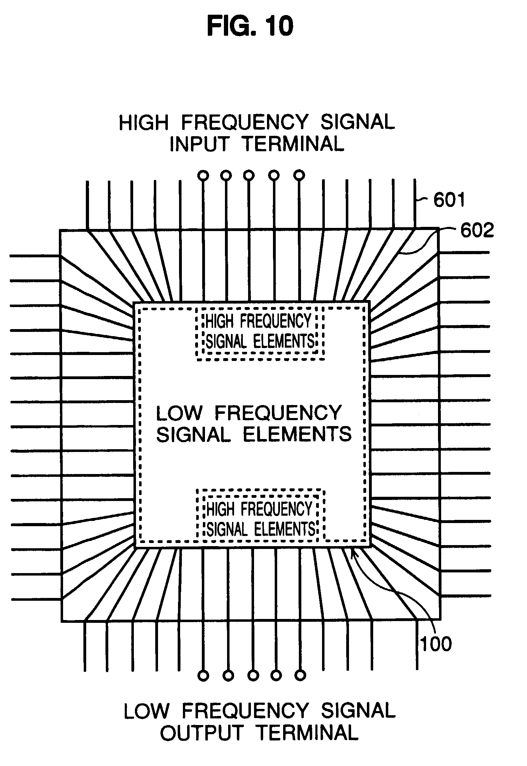

Fig. 9 is a block diagram showing a fourth embodiment of the invention. In this embodiment, the output of the P/S converter 13 is turned on-off according to a signal from the output control signal input terminal S. The remaining portions are the same as those in Fig. 1. Immunity to noise can be reduced, that is, erroneous operations due to noise can be reduced, by using a low cut-off frequency, high capacitance (parasitic capacitance) transistor as an element constituting the output control signal input terminal S. This fourth embodiment can be applied to the second and third embodiments shown in Figs. 5 and 6.

Fig. 10 shows an example of the pin location in a semiconductor integrated circuit having both high frequency signal elements and low frequency signal elements. The high frequency signal elements are located as close as possible (at a periphery portion) to the high frequency signal input and output terminals (or pins) to make high frequency signal current loops as short as possible. By so doing, it is possible to reduce electromagnetic irradiation due to the high frequency signals, which is the most serious problem in the electromagnetic irradiation. In Fig. 10, reference numeral 601 designates the input and output pins, and reference numeral 602 designates inter-connections.

While the above third and fourth embodiments also relate to the application of the invention to a semiconductor integrated circuit which is for serial-parallel conversion and for carrying out digital signal processing, the invention is generally applicable to any semiconductor integrated circuit having a high speed operation circuit section and a low speed operation circuit section.

While the third and fourth embodiments used the MOS transistors as operating elements, the invention is also applicable to other semiconductor integrated circuit, for instance using bipolar transistors.

As has been described in the foregoing, in the structure according to the invention which comprises a high speed operation circuit section required to perform an operation at a high speed and a low speed operation circuit section required to perform an operation at a lower speed, the low speed operation circuit section is constructed with long rise and fall time elements. The electromagnetic irradiation is thus reduced at least in the low speed operation circuit section constructed with the longer rise and fall time elements, although the high speed operation circuit section has to be realized with the short rise and fall time gates.

For example, by implementing the low speed operation circuit section elements with MOS transistors each having a longer channel than high speed operation circuit section MOS transistors, it is possible to suppress the electromagnetic irradiation from the low speed operation circuit section with longer MOS transistor rise and fall times thereof.

Further, by setting the bias voltage supplied to the low speed operation circuit section elements to be lower than the bias voltage supplied to the high speed operation circuit section elements, it is possible to provide longer rise and fall times for the MOS transistors in the low speed operation circuit section and suppress the electromagnetic irradiation therefrom.

Furthermore, by implementing the low speed operation circuit section elements with MOS transistors having a higher capacitance (parasitic capacitance) of the high speed operation circuit section MOS transistors, it is possible to provide longer rise and fall times for the MOS transistors in the low speed operation circuit section and suppress the electromagnetic irradiation therefrom.

While the invention has been described in its preferred embodiments, it is to be understood that the words which have been used are words of description rather than limitation and that changes within the purview of the appended claims may be made without departing from the true scope of the invention as defined by the claims.

## Claims

1. A semiconductor integrated circuit characterized by comprising:

   a high speed operation circuit section (11,13,14) required to perform a high speed operation; and
   a low speed operation circuit section (12) allowed to be operated at a lower speed than that of said high speed operation circuit section, in which rise and fall times are longer than those in said high speed operation circuit section.

2. A semiconductor integrated circuit according to claim 1, in which said low speed operation circuit section is MOS transistors having channels longer than those of MOS transistors constituting said high speed operation circuit section.

3. A semiconductor integrated circuit according to claim 1, in which said low speed operation circuit section is constructed such that it receives a bias voltage lower than that supplied to said high speed operation circuit section.

4. A semiconductor integrated circuit according to claim 1, in which said low speed operation circuit section has at its output a parasitic capacitance higher than that in said high speed operation circuit section and a cut-off frequency lower than that in said high speed operation circuit section.

5. A semiconductor integrated circuit according to claim 2, in which said high speed operation circuit section comprises a control signal input terminal (S) for controlling signal output, said control signal input terminal including a transistor having a parasitic capacitance higher than that of said high speed operation circuit section.

6. A semiconductor integrated circuit according to claim 3, in which said high speed operation circuit section comprises a control signal input terminal (S) for controlling signal output, said control signal input terminal including a transistor having a parasitic capacitance higher than that of said high speed operation circuit section.

7. A semiconductor integrated circuit according to claim 4, in which said high speed operation circuit section comprises a control signal input terminal (S) for controlling signal output, said control signal input terminal including a transistor having a parasitic capacitance higher than that of said high speed operation circuit section.

8. A semiconductor integrated circuit according to claim 2, in which said high speed operation circuit section is disposed at a periphery portion of a wafer to minimize a length of a loop formed by high speed operation signals.

9. A semiconductor integrated circuit according to claim 3, in which said high speed operation circuit section is disposed at a periphery portion of a wafer to minimize a length of a loop formed by high speed operation signals.

10. A semiconductor integrated circuit according to claim 4, in which said high speed operation circuit section is disposed at a periphery portion of a wafer to minimize a length of a loop formed by high speed operation signals.

11. A semiconductor integrated circuit according to claim 2, in which said high speed operation circuit section is a serial signal processing circuit (101;101') and said low speed operation circuit section is a parallel signal processing circuit (102;102').

12. A semiconductor integrated circuit according to claim 3, in which said high speed operation circuit section is a serial signal processing circuit (101;101') and said low speed operation circuit section is a parallel signal processing circuit (102;102').

13. A semiconductor integrated circuit according to claim 4, in which said high speed operation circuit section is a serial signal processing circuit (101;101') and said low speed operation circuit section is a parallel signal processing circuit (102;102').

# FIG. 1 PRIOR ART

# FIG. 2 PRIOR ART

# FIG. 3

# FIG. 4A

1ns

# FIG. 4B

3ns

## FIG. 5

100

14
1/n

11
S/P
CONVERTER

12
DIGITAL
SIGNAL
PROCESSOR

13
P/S
CONVERTER

15A — HIGH
VOLTAGE
BIAS CIRCUIT

LOW
VOLTAGE
BIAS CIRCUIT — 15B

## FIG. 6

101'

102'

100

14
1/n

11
S/P
CONVERTER

12
DIGITAL
SIGNAL
PROCESSOR

13
P/S
CONVERTER

BIAS CIRCUIT — 15

**FIG. 7A**

1ns

100ns

**FIG. 7B**

5ns

100ns

**FIG. 9**

| 101 | 102 | 100 |
|-----|-----|-----|

12

14
1/n

11
S/P CONVERTER

DIGITAL SIGNAL PROCESSOR

13
P/S CONVERTER

○ S

BIAS CIRCUIT ～15

**FIG. 8**

o : HIGH HARMONIC WAVES OF FIG. 7A
▲ : HIGH HARMONIC WAVES OF FIG. 7B

$f = \dfrac{1}{\pi \, tr} = 63\text{MHz}$ (FIG. 7B CASE)

$f = \dfrac{1}{\pi \, tr} = 318\text{MHz}$ (FIG. 7A CASE)

ENVELOPE IN FIG. 7A CASE

ENVELOPE IN FIG. 7B CASE

20dB/10 TIMES

40dB/10 TIMES

FOURIER COEFFICIENT SPECTRUM

3    5    7    9  11 13 15

NUMBERS OF
HIGH HARMONIC WAVES

f
FREQUENCY

13

# FIG. 10

HIGH FREQUENCY SIGNAL
INPUT TERMINAL

601

602

HIGH FREQUENCY
SIGNAL ELEMENTS

LOW FREQUENCY
SIGNAL ELEMENTS

HIGH FREQUENCY
SIGNAL ELEMENTS

100

LOW FREQUENCY SIGNAL
OUTPUT TERMINAL